# EUROPEAN PATENT APPLICATION

(11) **EP 4 718 980 A1**
(43) Date of publication of application: **01.04.2026**
(21) Application number: 25205013.3
(22) Date of filing: 26.09.2025
(51) Int. Cl.: H10D 30/01, H10D 30/66, H10D 64/00, H10D 64/27

(54) **A METHOD OF MANUFACTURING A SPLIT GATE TRENCH SEMICONDUCTOR COMPRISING A THICKER INTER-POLY OXIDE, IPO LAYER AND A SEMICONDUCTOR DEVICE COMPRISING A THICKER IPO LAYER**

(30) Priority: 26.09.2024 NL 2038721
(71) Applicant: Nexperia B.V., 6534 AB Nijmegen (NL)
(72) Inventor: Siddiqui, MD Imran, Manchester (GB); Dulal, Ravi Sharma, Manchester (GB); Havaldar, Dnyanesh, Manchester (GB); Gajda, Mark Andrzej, Manchester (GB); Waghmare, Parag, Manchester (GB); Hsu, Chih-Wei, Manchester (GB)
(74) Representative: Pjanovic, Ilija

(57) **Abstract**

A method of manufacturing a split-gate trench in a semiconductor material, said method comprising the steps of: providing a gate trench in said semiconductor material, said gate trench having an oxide material provided at a bottom side of said gate trench and provided on a sidewall of said gate trench, said gate trench further comprising a polysilicon material provided on top of said oxide material that is provided at said bottom side of said gate trench; providing a nitride spacer against the oxide material that is provided at the sidewall of the gate trench; growing an inter-poly oxide, IPO, on top of said polysilicon material, wherein said nitride spacer at least reduces growth of IPO at said oxide material provided at said sidewall, wherein IPO is grown preferentially and locally at said oxide material provided at a bottom-end of said nitride spacer; removing said nitride spacer.

## Description

### Technical Field

The present disclosure relates to split gate trench semiconductors and a method of manufacturing split gate trench semiconductors, controllably thickening the IPO layer.

### Background

Metal-Oxide-Semiconductor Field-Effect Transistors, MOSFETs, are components that are of importance in modern electronics, acting as switches or amplifiers in various digital and analog circuits. Traditional MOSFETs feature a single gate structure that controls the flow of electrical current between the source and drain terminals by creating an electric field in the channel region. This simple yet effective design allows for precise control of current flow, making MOSFETs essential for a wide range of applications, from microprocessors to memory devices.

Split-gate MOSFETs represent an evolution of the traditional MOSFET design, incorporating a gate structure, with a split gate. This split-gate architecture improves control over the channel region, leading to enhanced electrical characteristics such as reduced leakage current and faster switching speeds. The design may also offer better scalability, making split-gate MOSFETs suitable for use in highly integrated circuits and advanced technology nodes. The improved control and performance of split-gate MOSFETs make them a component that is of importance in semiconductor technologies.

The manufacturing process involves creating an Inter-Poly Oxide, IPO layer, which is important in defining the split-gate architecture. The IPO layer serves as an insulating layer between the polysilicon electrodes of the split-gate MOSFET. During the manufacturing of such IPO layer, a problem may arise concerning the thickness of the IPO layer with respect to the sidewall. This is because a thin bottom gate oxide in split-gate MOSFETs is prone to premature breakdown, leading to Bottom Gate Oxide (BVOX) failure.

### Summary

It would be advantageous to achieve a method of manufacturing a split-gate trench in a semiconductor material in order to achieve a wide range of inter-poly oxide, IPO, thicknesses, providing greater flexibility for robust process integration across various voltage platforms, and by solving the issue accompanied by thin IPO layers.

In the first aspect of the present disclosure, there is provided a method of manufacturing a split-gate trench in a semiconductor material, said method comprising the steps of:
- providing a gate trench in said semiconductor material, said gate trench having an oxide material provided at a bottom side of said gate trench and provided on a sidewall of said gate trench such that an inside of said gate trench is insulated from said semiconductor material, said gate trench further comprising a polysilicon material provided on top of said oxide material that is provided at said bottom side of said gate trench;
- providing a nitride spacer against the oxide material that is provided at the sidewall of the gate trench;
- growing an inter-poly oxide, IPO, on top of said polysilicon material, wherein said nitride spacer at least reduces growth of IPO at said oxide material provided at said sidewall, wherein IPO is grown preferentially and locally at said oxide material provided at a bottom-end of said nitride spacer;
- removing said nitride spacer.

The inventors have found that it may be beneficial to provide a nitride spacer against the oxide material that is provided at the sidewall of the gate trench in order to control the growing of the IPO at roughly the middle of the gate trench.

Herein the nitride spacer is installed to at least substantially inhibit growth of the oxide material that is provided at the sidewall of the gate trench. Note that this inhibition is an at least substantial inhibition: At the top of the trench the growth of the IPO may be (almost) completely prevented or inhibited, while when going down to the end of the nitride spacer, the reduction is less pronounced. The inventors have found that this may help in the formation of a thicker IPO. After the growth of the IPO, the nitride spacer may be removed.

A thicker IPO may help in solving the problem of the prior art thereby preventing or reducing the likelihood of Bottom Gate Oxide, BVOX, failure. This relates to, among others, defects introduced during the manufacturing process, such as irregularities in the oxide thickness, which can create weak points in the oxide layer. These defects may become sites for premature breakdown under electrical stress. Therefore, the ability of controlling the IPO is beneficial in preventing the BVOX failure.

In an example of the disclosure, a step of providing a gate oxide growth, which is positioned at the sidewall of the gate trench, may be performed prior to or posterior to the step of growing said IPO.

The gate oxide may not be identical to the liner oxide which is typically provided at the start of the manufacturing process. This liner oxide may experience etching steps or other steps that may damage the liner such that it is not beneficial to use it in the final split-gate trench. Therefore, the liner oxide at the top half of the gate trench, which is the part of the liner oxide that may experience contamination due to etching steps or otherwise, may be removed. After this removal a step of growing the gate oxide, GOX, may be performed. As mentioned, this may be before or after the growing of the IPO, depending on the preferences of the manufacturer.

In an example of the disclosure, said step of providing said nitride spacer comprises:
- providing said nitride spacer such that said nitride spacer extends downwards from a top surface of said semiconductor material into said gate trench.

As mentioned before, the nitride spacer is arranged to at least substantially prevent or inhibit the growth of oxide material that is provided at the sidewall of the gate trench. Therefore, it would be beneficial to extend this nitride spacer from the top surface into the gate trench.

In an example of the disclosure, said nitride spacer extends to a top side of said polysilicon material.

Therefore, it would be beneficial to extend this nitride spacer from the top surface into the gate trench, such that the thickening location of the IPO is reached, which is roughly at the top of the polysilicon material. At this location, the IPO is grown, in order to provide an insulative layer between the two electrodes of the split-gate trench. It may be beneficial to thicken the IPO, with respect to the oxide provided at the sidewall as it may improve dynamic parameters such as Qgd and associated FOMs. Qgd is the amount of charge required to switch the MOSFET's gate from the off-state to the on-state concerning the drain. Therefore, improving the Qgd means decreasing the current needed for the switching between on and off. This may decrease the switching losses and may improve the possible switching speeds.

In an example of the disclosure, said step of growing comprises:
- growing said oxide material provided at said bottom end of said nitride spacer such that said nitride spacer deflects in a direction towards an inside of said gate trench.

Growing the oxide material to deflect the nitride spacer to thicken the IPO layer has some additional advantages such as the formation of a unique IPO and a straight mesa profile. A straight mesa profile may lead to lower mesa loss, which in turn reduces Rds(on) by keeping the mesa as wide as possible. The unique shape of the IPO grown using the said technique removes the weak point, i.e. narrowing of gate oxide, from the nexus of gate oxide and IPO oxide. Now the nexus point is no longer thinner than the nominal gate oxide thickness on the sidewall but substantially thicker and gradually increases towards an inside of the said trench, which leads to improved reliability and dynamic switching performance.

There are even more advantages, such as reduced process steps, which results in a cheaper process flow, and a freedom to decide the IPO layer thickness without compromising mesa thickness. This is because as mentioned, the nitride spacer at least substantially inhibits or at least reduces the oxide growth at all covered locations except for the bottom part, which may be considered as partially exposed. This will lead the region around the tip to grow and will cause the nitride spacer to deflect or bend. It should be noted that this deflection is in the direction of the center of the gate trench. This is a logical behaviour, as the deflection is caused by a (gradual) increase of the oxide thickness at the IPO. The IPO therefore "pushes" the nitride spacer inwards.

In an example of the disclosure, said nitride spacer also covers a top side of said semiconductor material.

At the top side of the semiconductor material, it would be beneficial to extend the nitride spacer such that the top side is covered. This is because as mentioned before, the oxide region around an end of the nitride spacer may be grown. This in turn would lead to a bending of the nitride spacer at the top side of the semiconductor material. As a goal is to increase the thickness of the IPO, all other locations provided with oxide should be shielded. This helps in preventing irregularities in the oxide layer, which is beneficial for the stability of the electric field and the semiconductor.

In an example of the disclosure, said oxide material is provided on top of said polysilicon material.

The oxide material on top of the polysilicon may be grown, because the insulation layer between the polysilicon material and a further gate polysilicon material may then be increased in thickness, improving its capabilities. Depending on the desired shape of the resulting IPO, it may be chosen to include oxide on top of the bottom polysilicon material. This allows for flexibility in the manufacturing process.

In an example of the disclosure, said method comprises the step of:
- after removing said nitride spacer, cleaning said grown IPO and sidewall oxide.

A cleaning step has the advantage of at least substantially removing any inaccuracies and contaminants in the gate trench, as during fabrication, oxide layers can accumulate contaminants. This may be due to etching steps or due to other possible causes. These contaminants may adversely affect the electrical properties of the semiconductor device. The cleaning step may comprise removing part of the present oxide such that a clean oxide is resulted. This clean oxide may then be grown.

In an example of the disclosure, said method comprises the step of:
- implanting, when said nitride spacer is provided and before said step of growing the IPO, arsenic or argon on said polysilicon material.

Arsenic or Argon may be implanted in the polysilicon, this may stimulate the oxide growth of the IPO. This allows for a more controlled IPO growth, as the implant concentration may be deliberately increased or decreased to obtain a desired growth speed. Therefore, using an implant allows for more control during the fabrication process, which may be desirable. This step is flexible, as the implantation of Arsenic or Argon may be performed at any suitable step, provided that the implantation step is performed prior to the growing of the IPO. As that is desired to be influenced by the implantation elements.

In an example of the present disclosure, said step of removing said nitride spacer comprises:
- etching said nitride spacer in orthophosphoric acid or by an other appropriate wet-chemistry method.

After the controlled growing of the IPO, a further gate polysilicon material may be deposited in the gate trench, but prior to the inclusion of such element, the nitride spacer should be removed. This is because the nitride spacer itself may not possess desirable properties such that it is beneficial to use in a gate trench semiconductor. Therefore, the nitride spacer is to be removed. This may be done by using an orthophosphoric acid, as it may dissolve the nitride spacer without (significantly) damaging the surrounding components that are carefully fabricated during their respective process steps. Furthermore, removing the nitride spacer allows for further etching steps.

In an example of the disclosure, said method comprises the step of:
- providing a further gate polysilicon material on top of said IPO.

As the name split gate trench suggests, there are two electrodes, which are split. The bottom of the two split gate trench electrodes may not be a "gate" but may function as a bias or as a source electrode. In any case, the two split gates are separated by the Inter-poly oxide, this name also reflects its use, as it is an oxide positioned in between the two polysilicon electrodes. On the IPO the further gate polysilicon is provided.

In an example of the disclosure, said polysilicon material forms a source connection of said split-gate trench and wherein said further polysilicon material forms a gate connection of said split-gate trench.

As mentioned before, the (bottom) polysilicon material may form a source connection. The connection of the bottom electrode to the source helps in controlling the electric field distribution within the device, especially in the mesa region. The source electrode primarily controls the e-field in the mesa. This control may be of importance in preventing high electric fields to be present near the gate oxide, which could lead to increased leakage currents. Furthermore, the source connection to the bottom electrode may ensure that the current flow through the device is optimized.

In a second aspect of the disclosure, there is provided a semiconductor device having a split-gate trench manufactured in accordance with the disclosure.

The inventors have found that it may be beneficial to obtain a split gate semiconductor device in accordance with the disclosure, which comprises an IPO layer, which is fabricated in controlled fabrication steps. As it may improve the specific on resistance, Rdson, among other advantages mentioned above.

In an example of the disclosure,
- said oxide material preferentially and locally grown in between a bottom side of said gate polysilicon material forming a gate connection and said semiconductor material
   is thicker than
- said oxide material provided in between a top side of said polysilicon material forming said gate connection and said semiconductor material.

As mentioned, the inclusion of a nitride spacer at least substantially inhibits or at least reduces the oxide growth of the sidewall oxide, at the end of the nitride spacer, oxide may growth because at that location the oxide is not (completely) shielded anymore, allowing oxide growth, this will bend the nitride spacer. This bending is due to an increasing IPO thickness near the end of the nitride spacer. Therefore, the oxide near the top of the (bottom) polysilicon material is thicker than the oxide material near the top of the gate polysilicon material.

In an example of the disclosure, a thickness of said oxide material at said sidewall gradually, at said bottom side, increases for increasing depth in said trench.

If a part of the oxide is shielded, which is the case when a nitride spacer is present, oxide shielded by the nitride spacer but near unshielded oxide may be grown albeit less effectively. This effect is more pronounced nearer to the unshielded oxide and more suppressed the further away from unshielded oxide. Therefore, a gradual thickness increase from the top of the trench, where the oxide is completely shielded, may show. This increased thickness near the IPO is beneficial as it has a number of advantages that are already mentioned before. One of which is improving manufacturability.

In an example of the disclosure, said semiconductor device is a Metal Oxide Semiconductor, MOS, Field Effect Transistor, FET.

The split gate shield may be incorporated in a MOSFET. This has several advantages. Firstly, the split gate design may improve electrostatic control over the channel, reducing short-channel effects and providing better threshold voltage stability. This results in more precise device performance. Secondly, the split gate structure may reduce the Miller capacitance by isolating the gate from the drain, allowing faster switching speeds and lower switching losses. This improvement may be beneficial in high-frequency power conversion and amplification circuits, where efficiency and speed are important.

In an example of the present disclosure, the sidewall oxide is grown prior to the IPO growth.

In an example of the present disclosure, the sidewall oxide is grown after the IPO growth.

### Brief description of the figures

Fig. 1 depicts an example of the disclosure, showing a method of providing a trench in semiconductor material;
Fig. 2 depicts a method of providing a nitride spacer;
Fig. 3 depicts the deflection of the nitride spacer;
Fig. 4 depicts the removal of the nitride spacer;
Fig. 5 depicts the providing of oxide on top of the polysilicon material;
Fig. 6 depicts the providing of the nitride spacer and the growing of IPO;
Fig. 7 depicts the removal of the nitride spacer and the cleaning of the Si surface;
Fig. 8 depicts the implanting of arsenic in between after addition of nitride spacer and prior to growing of IPO;
Fig. 9 depicts the implanting of arsenic in between after addition of nitride spacer and prior to growing of IPO;
Fig. 10 depicts a workflow of adding nitride spacer to adding gate;
Fig. 11 depicts a method of manufacturing the split gate trench;
Fig. 12 depicts a method of manufacturing the split gate trench.

### Detailed description

It is noted that in the description of the figures, same reference numerals refer to the same of similar components performing a same of essentially similar function.

A more detailed description is made with reference to particular examples, some of which are illustrated in the appended drawings, such that the features of the present disclosure may be understood in more detail. It is noted that the drawings only illustrate typical examples and are therefore not to be considered to limit the scope of the subject matter of the claims. The drawings are incorporated for facilitating an understanding of the disclosure and are thus not necessarily drawn to scale. Advantages of the subject matter as claimed will become apparent to those skilled in the art upon reading the description in conjunction with the accompanying drawings.

The ensuing description above provides preferred exemplary embodiment(s) only, and is not intended to limit the scope, applicability, or configuration of the disclosure. Rather, the ensuing description of the preferred exemplary embodiment(s) will provide those skilled in the art with an enabling description for implementing a preferred exemplary embodiment of the disclosure, it being understood that various changes may be made in the function and arrangement of elements, including combinations of features from different embodiments, without departing from the scope of the disclosure.

Unless the context clearly requires otherwise, throughout the description and the claims, the words "comprise," "comprising," and the like are to be construed in an inclusive sense, as opposed to an exclusive or exhaustive sense; that is to say, in the sense of "including, but not limited to." As used herein, the terms "connected," "coupled," or any variant thereof means any connection or coupling, either direct or indirect, between two or more elements; the coupling or connection between the elements can be physical, logical, electromagnetic, or a combination thereof. Additionally, the words "herein," "above," "below," and words of similar import, when used in this application, refer to this application as a whole and not to any particular portions of this application. Where the context permits, words in the Detailed Description using the singular or plural number may also include the plural or singular number respectively. The word "or" in reference to a list of two or more items, covers all the following interpretations of the word: any of the items in the list, all of the items in the list, and any combination of the items in the list.

These and other changes can be made to the technology considering the following detailed description. While the description describes certain examples of the technology, and describes the best mode contemplated, no matter how detailed the description appears, the technology can be practiced in many ways. Details of the system may vary considerably in its specific implementation, while still being encompassed by the technology disclosed herein.

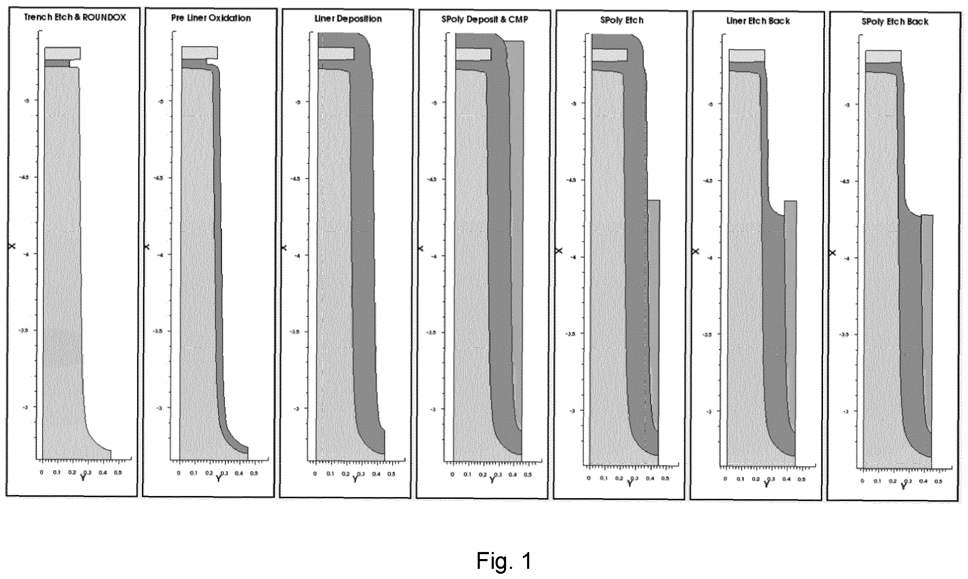

In figure 1 a part of the method of providing a trench in semiconductor material is depicted. The trench comprises a bottom polysilicon material, representing the "source" electrode of the split-gate. The polysilicon material is embedded in insulating oxide material. The oxide material furthermore is arranged against the semiconductor material. This oxide material is provided against the sidewall of the trench and also on top of the sidewall. This is etched such that the right most picture is resulted. The following steps are explained as being in between two figures going from left to right. In a first step, the pre-liner oxide is provided. In a second step the liner is deposited, effectively thickening the oxide layer against the semiconductor material. In a third step, the polysilicon material is deposited in the trench and in the following step, a part is etched and removed. In a fifth step, the liner is etched, after which the polysilicon material is further etched.

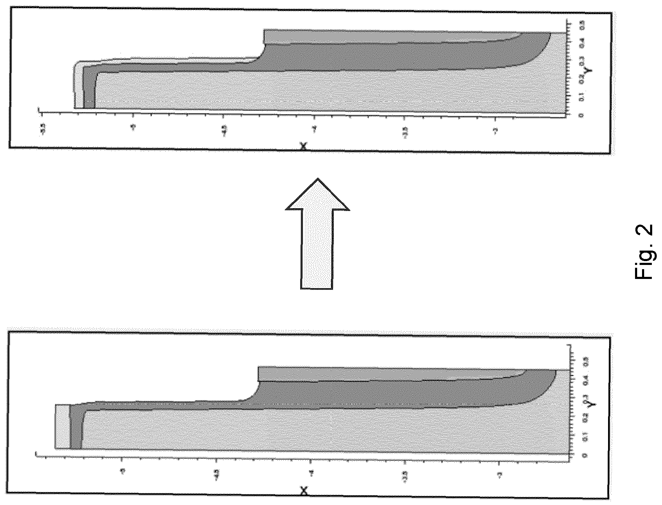

In figure 2 the providing of a nitride spacer is depicted, the trench comprises a nitride spacer in order to control the growth of the inter poly-oxide, IPO, layer in between the two gates of the split gates. The inclusion of said nitride spacer prevents the growth of the oxide at the top side of the trench.

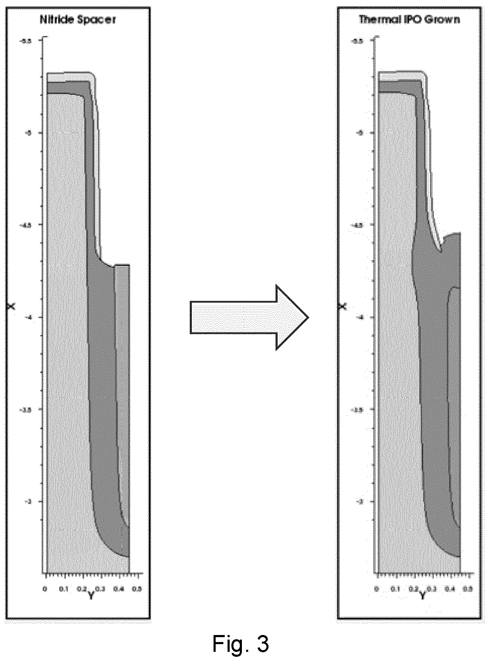

In figure 3 the growth of IPO is depicted. The nitride spacer is present in this step and will deflect or deform or bend. Furthermore, the IPO is thermally grown on top of the polysilicon material. Thermal oxidation may be used to produce a layer of oxide, in this case the IPO.

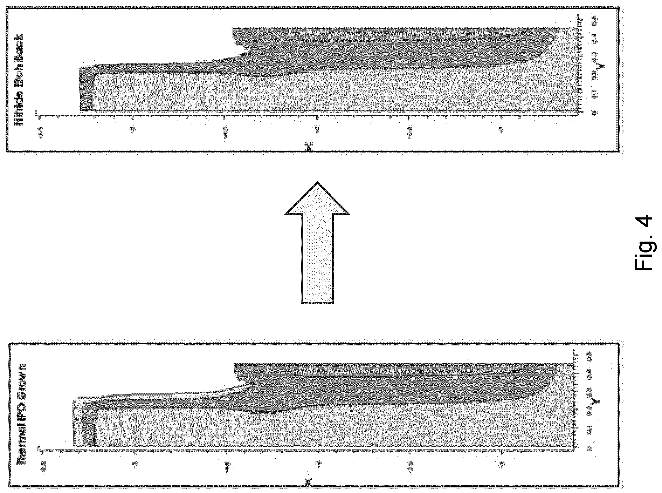

In figure 4, the removal of the nitride spacer is depicted. The nitride spacer was used to control the growth of the IPO, which may not be needed anymore. Because the nitride spacer may not have a functionality during the semiconductor operation, it may be removed by etch back.

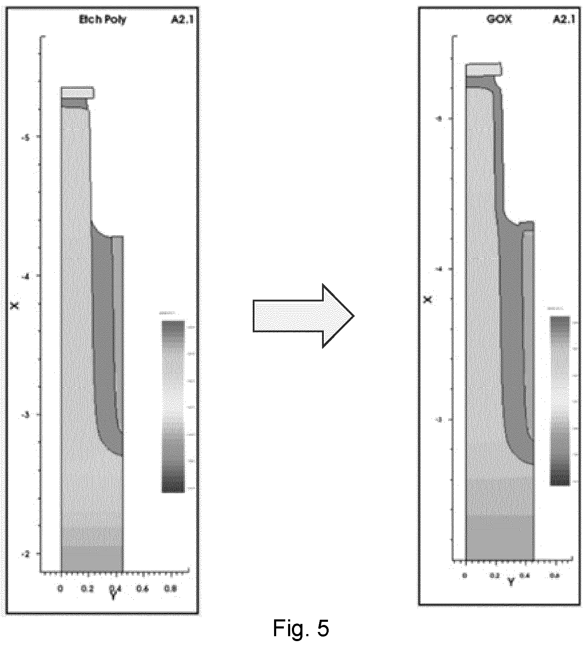

In figure 5, a step in an alternative process is shown, depicting a so-called gate-oxide-first workflow. First the trench is provided as in the right figure, this may be after the fourth step explained in the description of figure 1. Following this, the gate oxide is provided. The providing of gate oxide comprises providing the oxide on top of the polysilicon material. Said gate oxide may be grown in a further step.

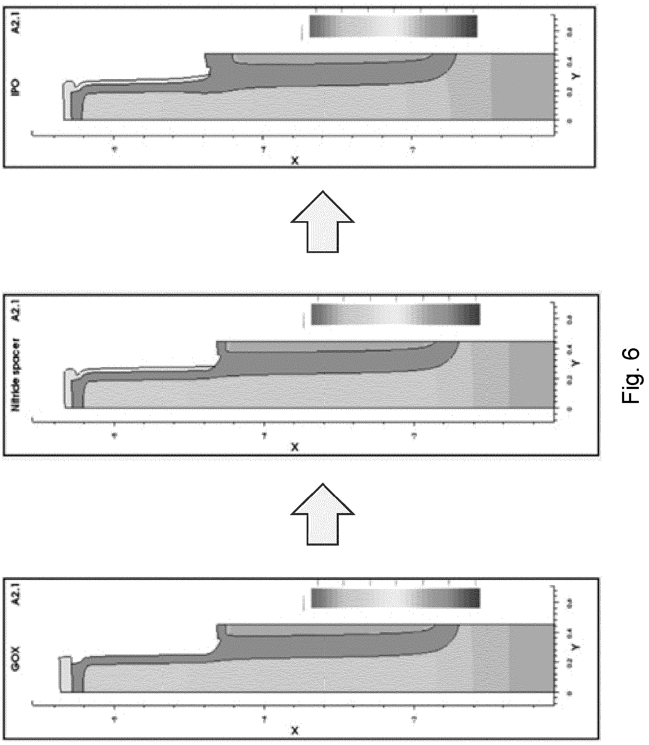

In figure 6, the addition of the nitride spacer pointing down into the trench is depicted. This may prevent or at least reduce the growth of the sidewall oxide. This is more effectively reduced at the top of the trench, allowing some oxide growth at the end of the nitride spacer, increasing the thickness of the IPO. In the next step, the IPO may be grown. Herein the deflection of the nitride spacer may be observed.

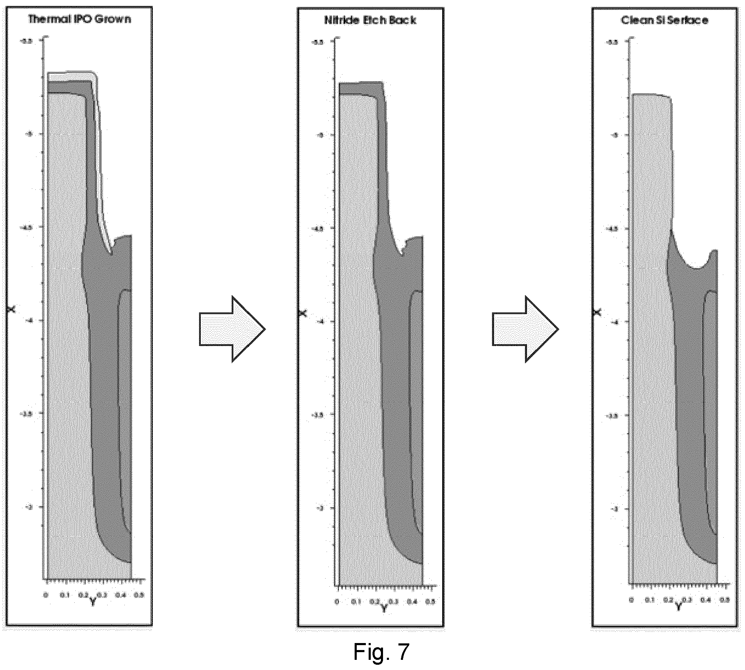

In figure 7, the situation follows figure 6 or figure 4, the last of which already performed the removal of the nitride spacer. In a first step, the nitride spacer may be removed using etch back, after which the silicon surface is cleaned. This results in a gradual IPO layer as may be observed, herein the sidewall oxide is removed or cleaned in order to at least substantially prevent contaminations and imperfections.

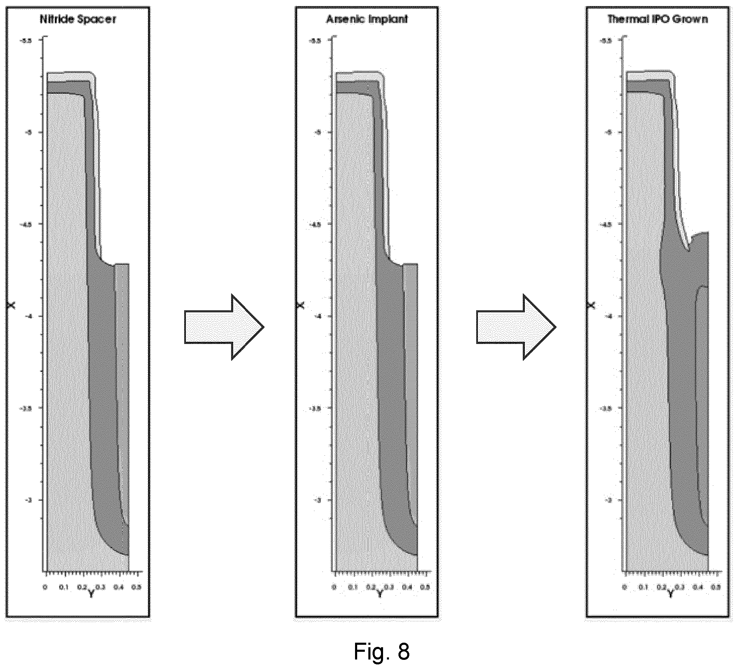

In figure 8 an additional step of arsenic implantation is depicted. This follows the step of the inclusion of the nitride spacer, the IPO is not grown yet. Arsenic is implanted prior to the thermal growth of the IPO, because the arsenic may facilitate the growth of the IPO layer. This allows for a speed up of the IPO growth, as the concentration may be chosen in reasonable values. It may also be implanted prior to the addition of the nitride spacer, this however warrants the removal of the oxide at the top of the trench, such that the oxide growth is not facilitated there.

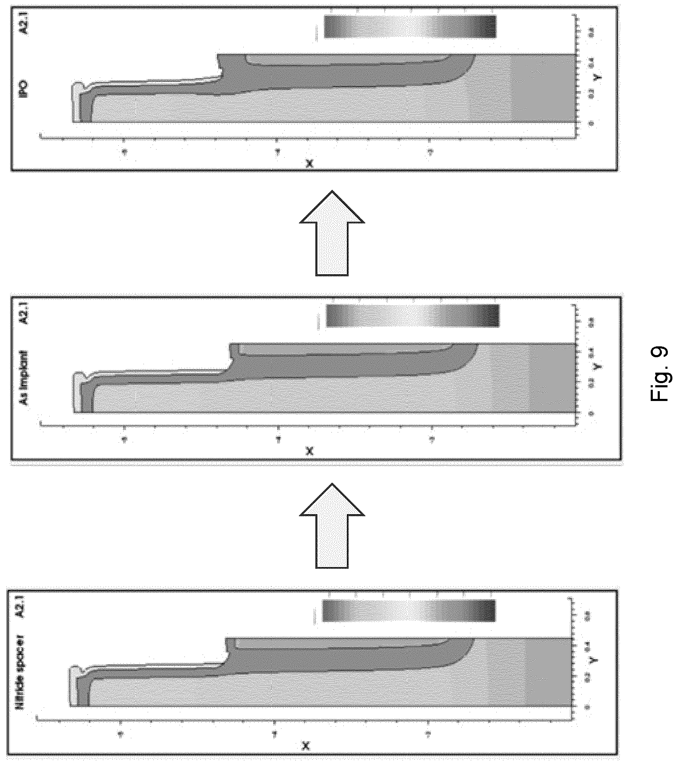

In figure 9 an additional step of arsenic implantation is depicted. In this example, gate oxide is present on top of the polysilicon. Arsenic is implanted prior to the thermal growth of the IPO. This is because the arsenic may facilitate the growth of the IPO layer. Furthermore, it may be implanted after the addition of the nitride spacer, in order to controllably cause an increased IPO growth speed, which is performed hereafter. It may also be implanted prior to the addition of the nitride spacer, this however warrants the removal of the oxide at the top of the trench, such that the oxide growth is not facilitated there.

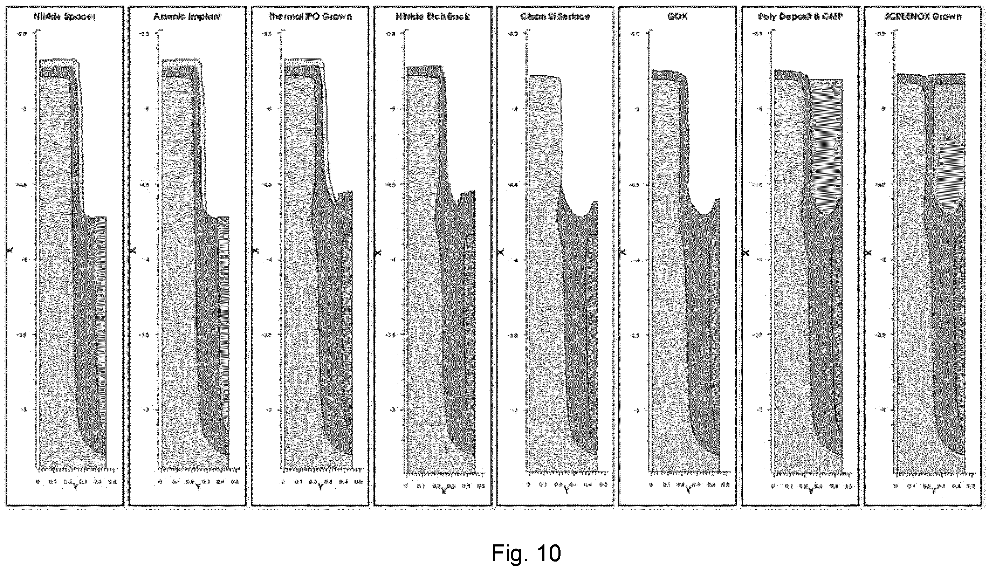

In figure 10 a proposed gate-oxide-last workflow is depicted, depicting the steps from the inclusion of the nitride spacer to the addition of the gate. In this proposed workflow, the arsenic implantation is depicted, which is an optional step. Furthermore, the addition of the gate oxide and the deposition of the gate polysilicon is depicted.

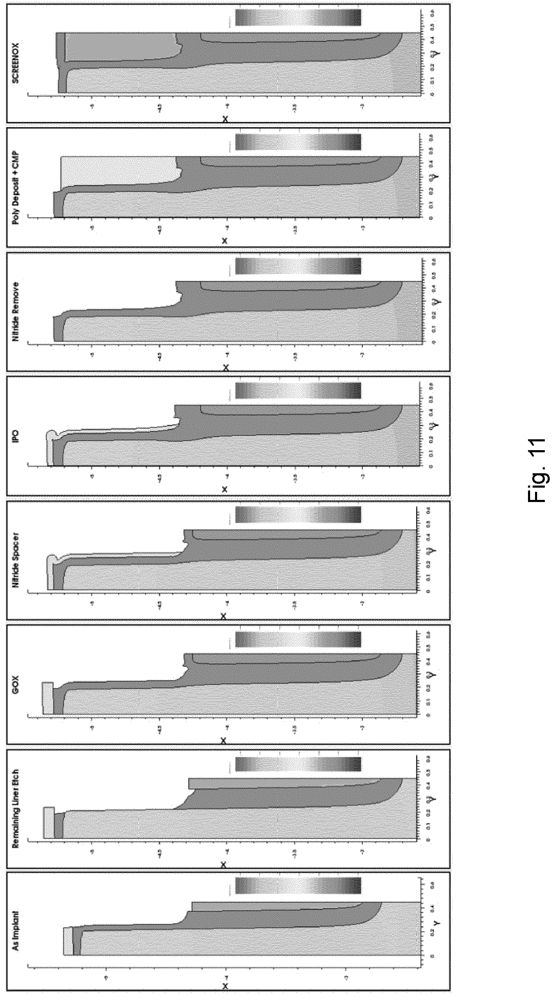

In figure 11 a proposed gate-oxide-first workflow is depicted, depicting the steps from the implanting of arsenic, etching the liner, which is the oxide positioned against the trench as depicted and providing gate oxide on top of the polysilicon. Hereafter the nitride spacer is included, and the IPO is grown, this is facilitated by the arsenic implantation. Then, the nitride spacer is removed, and the polysilicon gate is added.

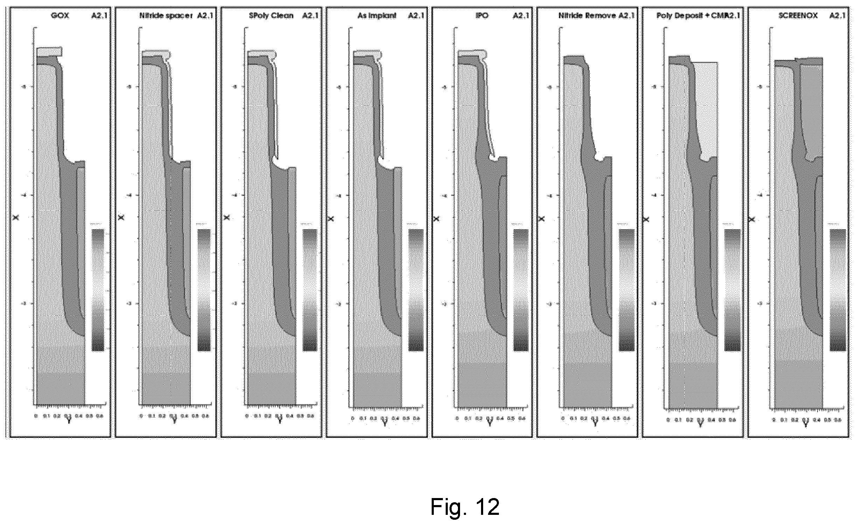

In figure 12 a proposed workflow is depicted, depicting the steps from the providing of the gate oxide on top of the polysilicon, to the addition of the polysilicon gate. These steps comprise the inclusion of the nitride spacer, an option of cleaning on the polysilicon, thereby removing oxide on top of the polysilicon and a part below the nitride spacer. After this, arsenic is implanted which enhances IPO growth, which is done in the following step. Hereafter, the nitride spacer is removed, and the polysilicon gate is added. This, as may be observed, allows for a unique gate polysilicon shape, which may be beneficial.

As noted above, particular terminology used when describing certain features or aspects of the technology should not be taken to imply that the terminology is being redefined herein to be restricted to any specific characteristics, features, or aspects of the technology with which that terminology is associated. In general, the terms used in the following claims should not be construed to limit the technology to the specific examples disclosed in the specification, unless the Detailed Description section explicitly defines such terms.

Accordingly, the actual scope of the technology encompasses not only the disclosed examples, but also all equivalent ways of practicing or implementing the technology under the claims

## Claims

1. A method of manufacturing a split-gate trench in a semiconductor material, said method comprising the steps of:
- providing a gate trench in said semiconductor material, said gate trench having an oxide material provided at a bottom side of said gate trench and provided on a sidewall of said gate trench such that an inside of said gate trench is insulated from said semiconductor material, said gate trench further comprising a polysilicon material provided on top of said oxide material that is provided at said bottom side of said gate trench;
- providing a nitride spacer against the oxide material that is provided at the sidewall of the gate trench;
- growing an inter-poly oxide, IPO, on top of said polysilicon material, wherein said nitride spacer at least reduces growth of IPO at said oxide material provided at said sidewall, wherein IPO is grown preferentially and locally at said oxide material provided at a bottom-end of said nitride spacer;
- removing said nitride spacer.

2. A method in accordance with claim 1, wherein said step of providing said nitride spacer comprises:
- providing said nitride spacer such that said nitride spacer extends downwards from a top surface of said semiconductor material into said gate trench.

3. A method in accordance with claim 2, wherein said nitride spacer extends to a top side of said polysilicon material.

4. A method in accordance with any of the claims 2 - 3, wherein said step of growing comprises:
- growing said oxide material provided at said bottom end of said nitride spacer such that said nitride spacer deflects in a direction towards an inside of said gate trench.

5. A method in accordance with any of the claims 2 - 4, wherein said nitride spacer also covers a top side of said semiconductor material.

6. A method in accordance with any of the previous claims, wherein said oxide material is provided on top of said polysilicon material.

7. A method in accordance with any of the previous claims, wherein said method comprises the step of:
- after removing said nitride spacer, cleaning said grown IPO and sidewall oxide.

8. A method in accordance with any of the previous claims, wherein said method comprises the step of:
- implanting, when said nitride spacer is provided and before said step of growing the IPO, arsenic or argon on said polysilicon material.

9. A method in accordance with any of the previous claims, wherein said step of removing said nitride spacer comprises:
- etching said nitride spacer in orthophosphoric acid or by an other appropriate wet-chemistry method.

10. A method in accordance with any of the previous claims, wherein said method comprises the step of:
- providing a gate polysilicon material on top of said IPO.

11. A method in accordance with claim 10, wherein said polysilicon material forms a source connection of said split-gate trench and wherein said gate polysilicon material forms a gate connection of said split-gate trench.

12. A semiconductor device having a split-gate trench manufactured in accordance with any of the previous claims.

13. A semiconductor device in accordance with claims 12, wherein
- said oxide material preferentially and locally grown in between a bottom side of said gate polysilicon material forming a gate connection and said semiconductor material
is thicker than
- said oxide material provided in between a top side of said polysilicon material forming said gate connection and said semiconductor material.

14. A semiconductor device in accordance with claim 13, wherein a thickness of said oxide material at said sidewall gradually, at said bottom side, increases for increasing depth in said trench.

15. A semiconductor device in accordance with any of the claims 12 - 14, wherein said semiconductor device is a Metal Oxide Semiconductor, MOS, Field Effect Transistor, FET.
